# EUROPEAN PATENT SPECIFICATION

(11) **EP 2 230 326 B1**
(45) Date of publication and mention of the grant of the patent: **25.07.2012**
(21) Application number: 09155275.2
(22) Date of filing: 16.03.2009
(51) Int. Cl.: C23C 14/54, C23C 14/24

(54) **Evaporator, coating installation, and method for use thereof**
Verdunster, Beschichtungsanlage und Anwendungsverfahren dafür
Évaporateur, installation de revêtement et leur procédé d'utilisation

(43) Date of publication of application: 22.09.2010
(73) Proprietor: Applied Materials, Inc., Santa Clara, CA 95054 (US)
(72) Inventor: Martini, Marcel, 63457, Hanau (DE); Gebele, Thomas, 63579, Freigericht (DE); Hoffmann, Uwe, 63755, Alzenau (DE); Bangert, Stefan, 36396, Steinau (DE); Koenig, Michael, 60529, Frankfurt am Main (DE)
(74) Representative: Zimmermann & Partner

(56) References cited:
- WO-A-2004/105095
- US-A1- 2007 089 524

## Description

### TECHNICAL FIELD OF THE INVENTION

Embodiments relate to an evaporator, a coating installation and a method for applying vapor to a substrate. Embodiments particularly relate to an evaporator with a measurement means for measuring the coating rate of the evaporator, a coating installation having such an evaporator and a method for applying vapor to a substrate.

### BACKGROUND OF THE INVENTION

Evaporators are needed in various technical fields. For instance, organic evaporators are an essential tool for certain production types of organic light-emitting diodes (OLED). OLEDs are a special type of light-emitting diodes in which the emissive layer includes a thin-film of certain organic compounds. Such systems can be used in television screens, computer displays, portable system screens, and so on. OLEDs can also be used for general space illumination. The range of colours, brightness, and viewing angle possible with OLED displays are greater than that of traditional LCD displays because OLED pixels directly emit light and do not require a back light. Therefore, the energy consumption of OLED display is considerably less than that of traditional LCD displays. Further, the fact that OLEDs can be printed onto flexible substrates opens the door to new applications such as roll-up displays or even displays embedded in clothing.

The performance of products manufactured using evaporators is often influenced by the thickness of evaporated layers. For instance, the functionality of an OLED depends on the coating thickness of the organic material. This thickness has to be within a predetermined range. In the production of OLEDs it is therefore important, that the coating rate at which the coating with organic material is effected lies within a predetermined tolerance range.

In other words, the coating rate, also called deposition rate, of evaporators, such as an organic evaporator, has to be controlled thoroughly in the coating process.

In order to do so, it is known in the art to use so called quartz crystal micro balances or quartz resonators for the determination of the coating rate. The measurement of the actual oscillating frequency of these oscillating crystals allows the conclusion on the actual coating rate. However, these crystals are also coated with material in the coating process. Therefore, the crystals have to be replaced periodically because they tolerate only a limited amount of material coating. This reduces their usability particularly in large scale production plants with very long services lives. Furthermore, in order to replace the oscillating crystals, interventions into the vacuum chamber are necessary. Regenerating the vacuum is time-consuming and expensive.

Alternatively, it is known in the art that the deposited layer is analyzed after the deposition is complete in order to determine the coating rate. In this case, the feedback control of the deposition system is only possible with a certain delay. In particular, this procedure can result in one or more substrates being coated with a layer that is out of range before the control can take corrective action.
WO2004/105095 discloses an evaporator for a coating installation comprising a crucible, an evaporator tube and a distribution pipe with nozzles. The evaporator tube or the distribution pipe includes a pressure measurement device. A method for applying organic vapor to a substrate using the pressure controlled evaporator is further disclosed.

### SUMMARY

In light of the above, it is provided an evaporator according to claim 1, a coating installation according to claim 10, and a method for applying vapor to a substrate according to claim 11.

In one embodiment an evaporator for applying vapor to a substrate at a coating rate is provided. The evaporator includes an evaporator tube having a distribution pipe with at least one nozzle outlet, and wherein the evaporator tube includes a pressure measurement device provided in the evaporator tube the pressure measurement device including an optical diaphragm gauge.

According to another embodiment, a coating installation for coating substrates is provided. The coating installation includes at least one evaporator for applying vapor to a substrate at a coating rate, the evaporator including an evaporator tube having a distribution pipe with at least one nozzle outlet, and wherein the evaporator tube includes a pressure measurement device provided in the evaporator tube, the pressure measurement device including an optical diaphragm gauge.

According to a further embodiment, a method for applying vapor to a substrate is provided with the steps of providing the vapor using an evaporator for applying vapor to a substrate at a coating rate, the evaporator including an evaporator tube having a distribution pipe with at least one nozzle outlet, and wherein the evaporator tube includes a pressure measurement device provided in the evaporator tube, the pressure measurement device including an optical diaphragm gauge, applying the vapor to the substrate, and measuring the pressure of the vapor within the evaporator tube.

Further features and details are evident from the dependent claims, the description and the drawings.

Embodiments are also directed to apparatuses for carrying out the disclosed methods and including apparatus parts for performing described method steps. Furthermore, embodiments are also directed to methods by which the described apparatus operates or by which the described apparatus is manufactured. They may include method steps for carrying out functions of the apparatus or manufacturing parts of the apparatus. The method steps may be performed by way of hardware components, firmware, software, a computer programmed by appropriate software, by any combination thereof or in any other manner.

### BRIEF DESCRIPTION OF THE DRAWINGS

So that the manner in which the above recited features of embodiments can be understood in detail, a more particular description of embodiments of the invention, briefly summarized above, may be had by reference to examples of embodiments. The accompanying drawings relate to embodiments of the invention and are described in the following. Some of the above mentioned embodiments will be described in more detail in the following description of typical embodiments with reference to the following drawings in which:

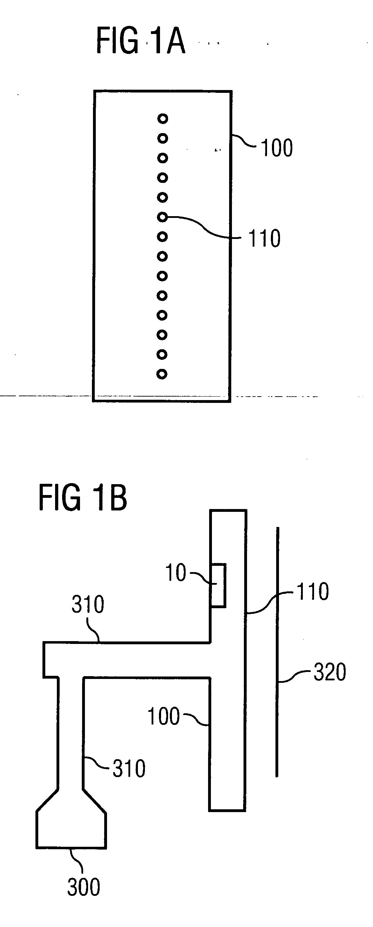

Figs. 1A and 1B schematically show an embodiment of the evaporator,
Fig. 1A illustrating a front view on a distribution pipe of the evaporator and
Fig. 1B illustrating a side view of the evaporator;

Fig. 2 schematically illustrates another embodiment of the evaporator;

Fig. 3 schematically illustrates a further embodiment of the evaporator;

Fig. 4 shows schematically a cross sectional side view of an embodiment of a coating installation;

Fig. 5 schematically illustrates a pressure measurement device of embodiments described herein;

Fig. 6A schematically shows a partial cross section of the distribution pipe of the evaporator shown in Fig. 1B;

Fig. 6B schematically illustrates an embodiment of the pressure measurement device provided in the evaporator shown in Fig. 6A;

Fig. 7 schematically shows a pressure measurement device of an embodiment;

Fig. 8 schematically illustrates a reference vacuum chamber of a pressure measurement device of embodiments;

Fig. 9 schematically illustrates two ways of coating the diaphragm and the window of an optical diaphragm gauge included in embodiments, and

Fig. 10 schematically shows a dive-in arrangement with multiple measurement heads of a pressure measurement device of embodiments.

It is contemplated that elements of one embodiment may be advantageously utilized in other embodiments without further recitation.

### DETAILED DESCRIPTION OF EMBODIMENTS

Reference will now be made in detail to the various embodiments, one ore more examples of which are illustrated in the figures. Each example is provided by way of explanation, and is not meant as a limitation of the invention.

Without limiting the scope, in the following the examples and embodiments are described referring to vacuum deposition of organic coatings and to an evaporator for applying organic vapor, also called herein organic evaporator. Typically, embodiments of the evaporator include vacuum-compatible materials and the coating installation is a vacuum coating installation. Typical applications of embodiments described herein are for example deposition applications, e.g. deposition of organic coatings, in the production of displays such as LCD, TFT displays and OLED (Organic Light Emitting Diode), in solar wafer manufacturing and in semiconductor device production

Within the following description of the drawings, the same reference numbers refer to the same components. Generally, only the differences with respect to the individual embodiments are described.

According to one embodiment, an evaporator for applying vapor, also called herein gas or evaporated material, to a substrate at a coating rate is provided. The evaporator has an evaporator tube having a distribution pipe with at least one nozzle outlet, and wherein the evaporator tube includes a pressure measurement device, the pressure measurement device including an optical diaphragm gauge (ODG). The ODG is also referred to herein as sensor or ODG sensor. The evaporator may be a linear evaporation source having an elongated distribution pipe, such as shown in Figs. 1A and 1B. Alternatively, the evaporator of embodiments described herein may be an area evaporation source.

The rate of the evaporator, also referred to herein as the deposition rate or coating rate, depends on the pressure of the evaporated material filling the evaporator tube, e.g. filling the distribution pipe. This pressure corresponds to the vapor pressure of the material. In e.g. linear evaporation sources, a homogeneous deposition rate is achieved by generating in the tube, e.g. in the distribution pipe, a pressure higher than outside of the tube. The pressure difference is correlated to the material flux from the source and therefore to the deposition rate. Higher pressure results in a higher rate. The tube and/or the distribution pipe typically have a high temperature, e.g. up to about 500°C for organic material, to prevent condensation of the evaporated material. Moreover, if a pressure sensor used for measuring the pressure adjacent to or in the evaporator is too hot, it could affect or damage the evaporated material in case that organic material is used.

With the evaporator of embodiments described herein an optical diaphragm gauge is used for measuring the pressure of the evaporated material within the evaporator tube. The optical diaphragm gauge according to embodiments may be used in a high temperature and/or high EMI (Electro Magnetic Interference) surrounding, and may in addition be corrosion resistant. Hence, the pressure measuring device of embodiments sustains the high temperatures and other conditions inside of the evaporation tube. Further, the pressure measuring device of embodiments does not damage the evaporation material, since the optical diaphragm gauge does not require high working temperatures. Therefore, a reliable and convenient pressure measurement can be conducted during evaporation directly inside of the evaporator tube, e.g. during evaporation of organic coating material in the manufacture of OLED devices.

A deposition rate control using embodiments described herein is fast, has substantially no dependence on the type of evaporated material and has no limitation in measuring time. In particular, the deposition rate control using embodiments described herein is a direct pressure measurement, which is substantially gas type or vapor type independent, utilizing the direct force of the pressure. Hence, the pressure measurement is not based on indirect gas properties such as conductivity or ionization. Therefore, gas conversion factors, which are not gas dependent, may be used for deposition control. The deposition rate measurement can be performed continuously over days and weeks, which allows a convenient structure and programming of a deposition rate controller.

Typically, the evaporator tube of embodiments is made of vacuum-compatible material, such as stainless steel. In the evaporator according to some embodiments, the optical diaphragm gauge includes a measuring section including a membrane, also called herein a diaphragm. In some embodiments, which can be combined with any other embodiment described herein, the membrane is made of at least one element selected from the group of a ceramic material, an Al₂O₃ material and Al₂O₃ from the type sapphire. In some embodiments, which can be combined with any other embodiment described herein, the optical diaphragm gauge is adapted to optically measure the pressure dependent deflection of the membrane. According to further embodiments, which can be combined with any other embodiment described herein, the membrane of the optical diaphragm gauge is provided between or separates a measurement vacuum chamber and a reference vacuum chamber. In some embodiments, which can be combined with any other embodiment described herein, the reference vacuum chamber may be fluidly connected to or may be a processing vacuum chamber, e.g. a coating chamber, in which the evaporator is provided for evaporation. Thereby, the pressure or the vacuum, respectively, in the processing chamber is or provides the reference pressure or reference vacuum, respectively, for operating the optical diaphragm gauge.

In typical embodiments, the evaporator further includes an analyzer, also called herein controller, that is linked to the pressure measurement device, e.g. by a data connection to a detector. The analyzer typically determines the coating rate based on the information supplied by the pressure measurement device. Further, typically, the analyzer has access to a memory. Data on typical coating rates of the vapor may be stored on the memory. For instance, the analyzer can include a personal computer, and the memory can be the hard drive of the personal computer or the like. The analyzer may have an input unit, such as a keyboard or a mouse to allow the operator to have influence on the actions of the analyzer and the units connected to the analyzer such as a controllable seat valve. Further, the analyzer may have an output unit, such as a screen or a plotter, for showing the operator information such as values received from the detector and/or calculation results calculated from these values. The data values measured and the data values stored in the memory may be jointly processed, e.g. compared, in order to determine the actual coating rate.

A gauging step may be performed in the method according to embodiments prior to the application of the vapor to the substrate. Generally, the correlation of the deposition rate and the pressure in the evaporator tube is gauged at the beginning of the coating. A gauging step can be repeated during evaporation e.g. in specific time intervals or constantly. It is also possible that gauging is undertaken during substrate coating. For instance, the coating thickness of the coated substrates can be examined directly after the coating step and be correlated to the pressure measured at the time of coating the respective substrate.

Fig. 1A shows a front view of a distribution pipe 100 of an embodiment of the evaporator. The distribution pipe 100 of the evaporator includes a multitude of nozzle outlets 110. The diameter of a typical distribution pipe according to embodiments is between 1 cm and 10 cm, more typically between 4 cm and 6 cm. When evaporating a substrate with organic material, the pressure within the distribution pipe, which is larger than the pressure outside, causes the organic vapor to stream out of the distribution pipe towards a substrate (not shown). In the view shown in Fig. 1A, the substrate would be positioned above the paper plane. In typical methods for coating a substrate, the organic vapor is applied to the substrate in a vacuum atmosphere. The term vacuum shall refer to a pressure of 10⁻² mbar and below. Typically, the nozzle outlets are shaped and arranged such that the flow of vapor of one nozzle outlet overlaps with the flow of vapor of a next neighbour nozzle outlet on the substrate surface, in order to optimize the layer uniformity.

Fig. 1B illustrates a side view of the evaporator shown in Fig. 1A. In order to control the coating rate, the organic evaporator according to the embodiment shown in Figs. 1A and 1B includes a measurement device 10 for acquiring pressure data of the organic vapor within the distribution pipe 100. The measurement device 10 is in the present embodiment adapted to acquire pressure data of the organic vapor within the distribution pipe. Therefore, the measurement device 10 may be provided at a wall of the distribution pipe, e.g. it may be positioned in or fill an opening of a wall of the distribution pipe.

Generally, the distribution pipe of embodiments can be a hollow body having at least one nozzle outlet 110. The distribution pipe 100 is typically connected with a feeding unit such as a crucible 300 for feeding the distribution pipe with organic vapor. In the present embodiment the distribution pipe is connected to the crucible via a supply tube 310. Typically, the distribution pipe includes between 15 and 100, typically between 20 and 30 nozzle outlets. The diameter of the nozzle outlets is typically between 0.1 mm and 5 mm, more particular between 1 mm and 2 mm. The distribution pipe can be shaped as tube or the like. In other embodiments, the distribution pipe is a shower head.

If the numbers of nozzles and their respective area of openings are small in comparison to the total size/volume of the distribution pipe, the pipe is considered to be a closed distribution pipe. Then, the pressure within the pipe is more stable and results in better coating processes and pressure measurements.

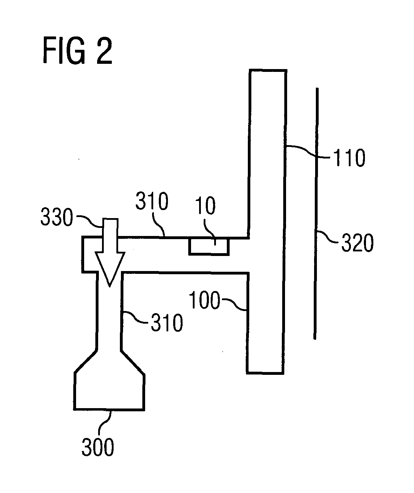

The embodiment shown in Fig. 2 is similar to the embodiment shown in Figs. 1A and 1B with the difference that the pressure measuring device 10 is positioned in the supply tube 310 of the organic evaporator.

It is further possible to arrange a seat valve somewhere between the crucible and the distribution pipe. This is exemplarily shown in the embodiment of Fig. 2, where the valve 330 is positioned between the vertical part of the supply tube 310 and its horizontal part. In the embodiment shown, the crucible is connected to the distribution pipe via the seat valve. The seat valve 330 is manually or automatically controllable. For instance, the seat valve may be completely closed if the deposition of organic material is to be temporarily stopped. In general, it can be controlled in order to control the organic material density within the organic evaporator. That is, the seat valve can be used for controlling the coating rate of the organic evaporator. Typically, the seat valve can be linked to and be controlled by the analyzer mentioned above. It is also possible that there are more than one seat valves installed in the organic evaporator according to embodiments. For instance, one seat valve could be controlled manually, and another seat valve could be controlled by the analyzer.

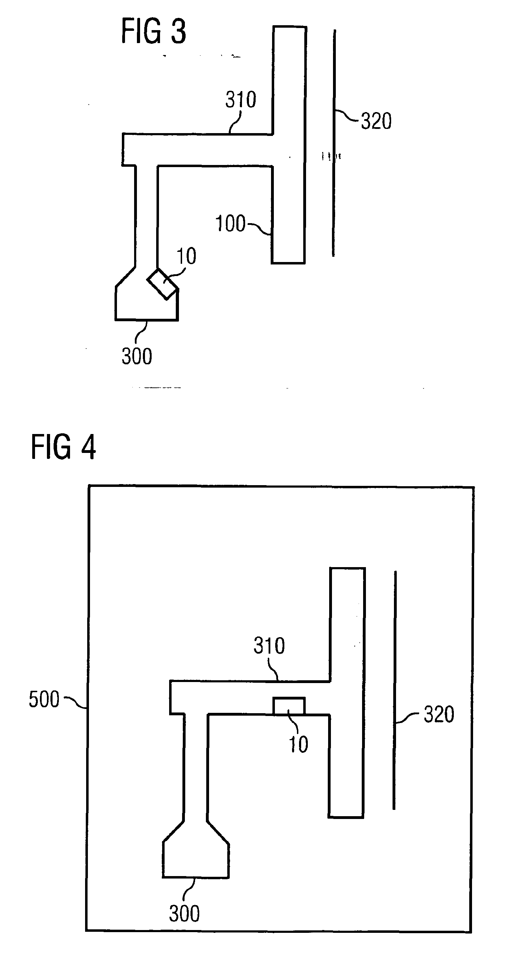

Fig. 3 shows a further embodiment of the organic evaporator, in which the pressure measurement device including an optical diaphragm gauge of embodiments described herein is provided in the crucible, for instance near the aperture of the crucible 300, which is connected to the supply tube 310.

In some embodiments, the organic evaporator includes the crucible 300 and one or more supply tubes 310. The crucible 300 can be filled with the organic material in solid or liquid form. The crucible is then heated to a temperature at which the material partly changes its state of aggregation into vapor.

Typically, the evaporator has a closed geometry. That is, the holes 110 are the only openings for the vapor to exit the organic evaporator. Due to the higher pressure within the organic evaporator in comparison to the pressure in the surrounding atmosphere, the vapor streams out of the distribution pipe onto a substrate 320. Typically, the pressure within the closed geometry of the organic evaporator corresponds to the vapor pressure of the organic material. This pressure is typically in the 10⁻² mbar range, for instance between about 2 x 10⁻² to 4 x 10⁻² mbar. Thereto in contrast, the pressure outside the organic evaporator may be between about 10⁻⁴ mbar and 10⁻⁷ mbar.

Fig. 4 is a cross sectional side view on an embodiment of a coating installation. Fig. 4 shows the organic evaporator of embodiments within a coating chamber 500 that is typically evacuated by one or more vacuum pumps (not shown) during operation.

Typically, the coating installation according to embodiments includes further process chambers which are positioned before and/or after the organic evaporator. The organic evaporator of embodiments is typically used as a vertical linear organic evaporator. Typically, the substrates are processed in-line. That is, the organic material is horizontally evaporated onto a substrate that is vertically oriented. The substrate is typically continuously transported by an assembly line with different process chambers being positioned in a row. In typical embodiments, the time interval needed for coating is in the range of between 10 seconds and 4 minutes, more typically between 30 sec and 90 sec for one substrate. The coating frequency refers to the number of substrates being coated in the time specified.

According to embodiments described herein, the coating installation may include several organic evaporators. The process chambers of the coating installation may have different levels of vacuum. Typically, the substrate to be coated undergoes one or more cleaning process steps before entering the chamber for organic evaporating. It is further typical that the substrate is coated with an inorganic layer after the deposition of one or more organic layers. This is due to the fact that organic materials are sensitive to oxygen. Therefore, a cap layer will protect the organic material layer in many embodiments.

Further, as the organic material can hardly be etched in a wet chemical etching process, it is typical that the substrates are structured with the help of shadow masks during the coating. The shadow mask is typically aligned to the substrate. Typically, a metal mask with a high local precision is aligned in relation to the substrate. The substrate is then coated.

According to embodiments described herein, the pressure measurement device of the evaporator includes an optical diaphragm gauge 10. In some embodiments, the optical diaphragm gauge 10 is a vacuum measuring cell which in one example includes a first housing body 1 made of an Al₂O₃ material, a membrane 2 made of an Al₂O₃ material and being arranged adjacent to the first housing body in a vacuum tight manner such that a reference vacuum chamber is created between the first housing body and the membrane. The vacuum measuring cell may include a second housing body 4 made of an Al₂O₃ material and provided opposite the membrane 2 in a vacuum tight manner such that a measurement vacuum chamber 26 is created between said second housing body and the membrane, said second housing body including a port 5 for connecting the measurement vacuum chamber to the interior of the evaporator tube. In the central area of the first housing body an optical transparent window 33 may be formed and at least in the central region of the membrane a surface of the membrane, which is located facing the optical transparent window, may be formed optically reflecting. Outside of the reference vacuum chamber in opposition to and at a distance from the window 33, a light feeding means, e.g one or more optical fibres 37, 37', may be arranged for feeding in and out light onto the surface 31 of the membrane 2. Further, a lens device 35 may be placed between the light feeding means 37, 37' and the window 33, also referred to herein as optical window, for optical linking to the surface 31, e.g. a mirror or a mirror coating, of the membrane 2. Thereby, the arrangement is forming a measuring section for determining the level of deflection of the membrane 2, e.g. using the Fabry-Perot interferometer principle by creating a Fabry-Perot Interferometer.

In another embodiment, which can be combined with any other embodiments described herein, the pressure measuring device includes a plug, the optical diaphragm gauge is provided in the plug, and the plug is mounted in an opening of the evaporator tube such that the measurement vacuum chamber of the optical diaphragm gauge is connected to the interior of the evaporator tube, the plug optionally consisting of quartz and being cone-shaped.

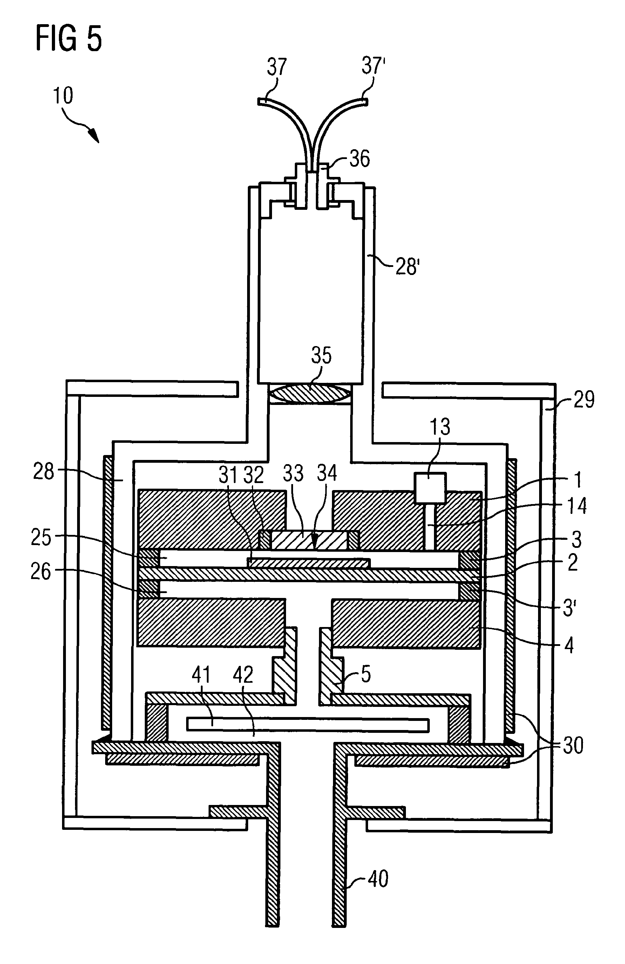

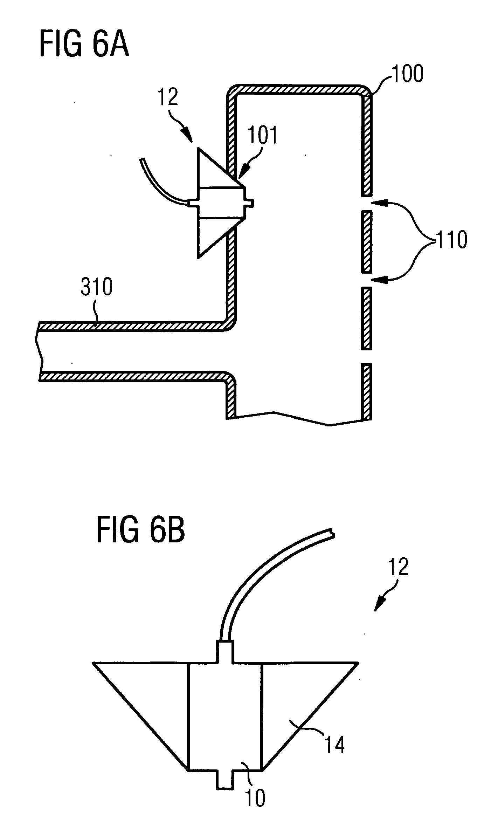

One example of a pressure measuring device is shown in Fig. 5, illustrating the optical diaphragm gauge 10. Figs. 6A and 6B show, as further examples of an embodiment, a pressure measurement device 12 including a plug 14 in which the optical diaphragm gauge 10 is provided. As shown in the example of Fig. 6B, the optical diaphragm gauge 10 may operably be provided within the plug 14. In one example, as illustrated in Fig. 6A, the pressure measuring device 12 is provided to detect the pressure within the distribution pipe 100 of the evaporator. The plug 14 may be provided in or fill an opening in the wall of the distribution pipe, such that the measuring vacuum chamber 26 of the optical diaphragm gauge 10 has access to the interior of the distribution pipe 100.

The plug 14 may for instance be formed of quartz. The plug 14 may in some examples be cone shaped and centrally enclose the optical diaphragm gauge 10. The plug 14 serves for mounting the pressure measurement device 12 operably in for instance the distribution pipe as shown in Fig. 1B. The cone shaped form further allows for mounting the pressure measurement device 12 by pushing it into an opening of the evaporator tube, in the present example an opening 101 of the distribution pipe 100. To this end, the material of the plug 14 may be chosen such that a tight seal, for instance a vacuum tight seal, between the plug 14 and the wall of the evaporator tube is provided when pushing the plug into the opening. Moreover, because of the plug 14, the pressure measurement device 12 is easily exchangeable.

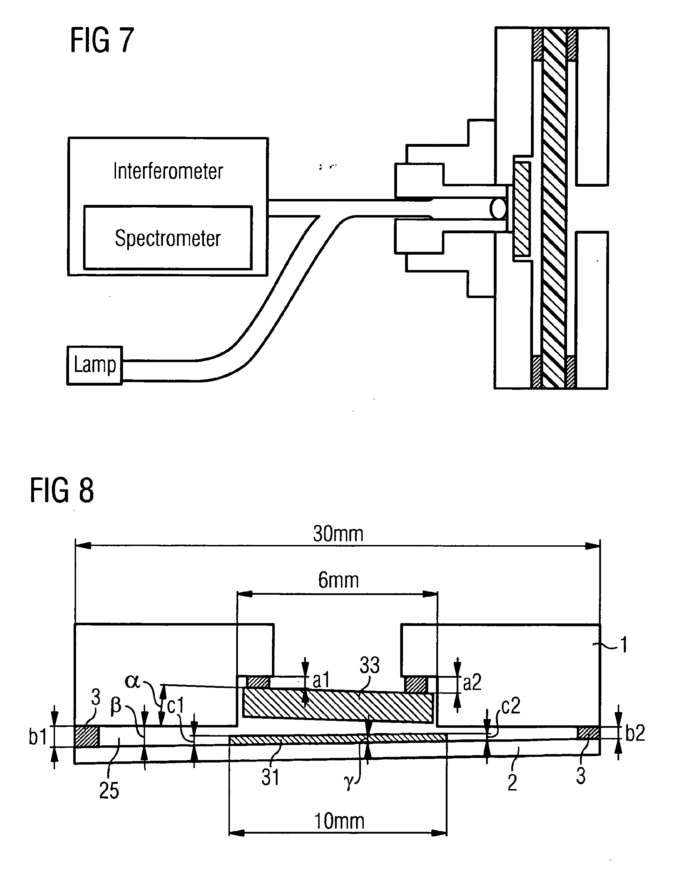

In a further embodiment, which may be combined with any other embodiment described herein, the light feeding means 37, 37' of the optical diaphragm gauge 10 is connected to the analyser of the evaporator. The analyser of one example includes an interferometer, a spectrometer and a lamp, as illustrated in Fig. 7. Thereby, light can be fed into and out of the optical diaphragm gauge 10 and analysed.

One embodiment of an ODG (Optical Diaphragm Gauge) measuring cell made of Al₂O₃ with a structure essentially symmetrical about the membrane is illustrated in Fig. 5. An ODG measuring cell of this type is described and depicted in US 7305888 B2, which is incorporated herein by reference. The first housing 1 consists of a ceramic plate made of Al₂O₃ which along its edges is tightly bonded at a distance of about 2 µm to about 50 µm relative to the membrane 2, thereby forming a reference vacuum chamber 25. Typically, the distance between the two surfaces of the ceramic plate 1 and the membrane 2 is established directly during the assembly by means of sealing material 3, 3' located between the membrane edge and the housing 1. In this way a completely plane housing plate 1 can be used. In the same way a measurement vacuum chamber 26 is formed in a second housing 4 on the opposite membrane side. The vacuum chamber 26 is accessible for the media to be measured via a connecting port 5 through an opening in the housing 4.

The seal 3, 3' on both sides of the membrane 2 defines, as mentioned above, the distance of the two housings 1 and 4. This seal consists, for example, of glass paste that is easy to handle and can, for example, be applied by means of screen printing. The prefusing or sintering temperature of this glass paste is e.g. in the range of about 675 °C to about 715 °C. And the sealing temperature is e.g. in the range of about 600 to about 630 °C. The seal 3, 3' may be formed of vacuum compatible material.

In a typical measuring cell with an external diameter of about 5 mm to about 50 mm, typically about 38 mm, and a free internal membrane diameter of about 4 mm to about 45 mm, typically of about 30 mm, the distance between the first and the second housing is approx. about 2 to 50 µm, typically about 12 to 35 µm. In this example the first housing 1 has a thickness of about 2 to 10 mm, the second housing 4 has the same thickness. The first housing 1 and the second housing 2 are typically made of materials having similar expansion coefficients as the used diaphragm materials. Very suitable combinations are high purity alumina ceramics (purity >96, typically >99.5%), sapphal ceramics (alumina having a purity above 99.9%) and sapphire (single crystal high purity alumina, artificial corundum). The inner area of the second housing 4 is typically designed with an approx. 0.5 mm deep recess, in order to enlarge the measurement vacuum chamber 26.

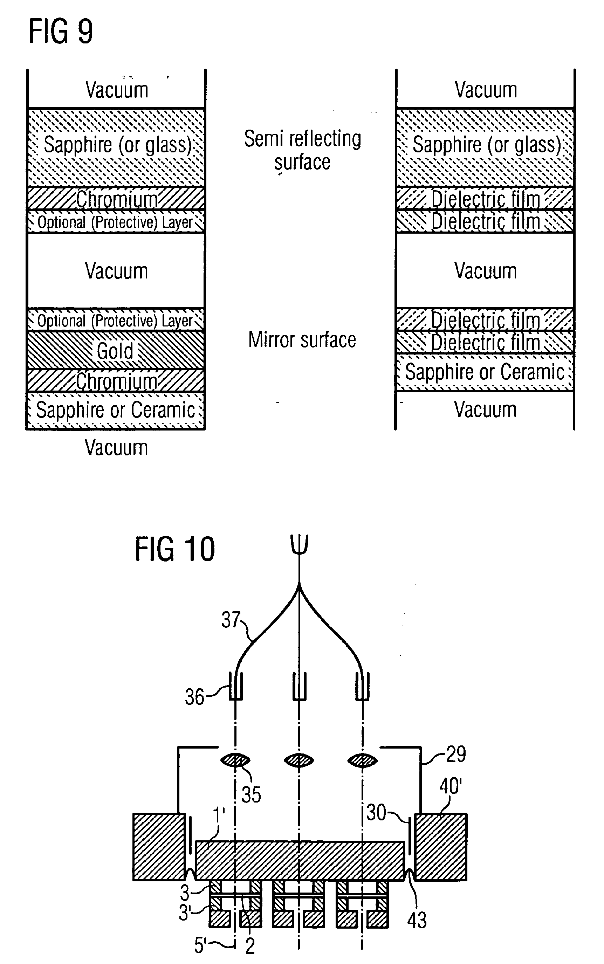

On the reference vacuum side the membrane 2 is coated with a reflecting film forming a mirror coating 31. There are two ways of coating the diaphragm 2 and the window or the first housing to create a Fabry-Perot Interferometer. The principle ideas of coatings that can be used in the Fabry-Perot Interferometer are well described in the literature (see Vaughan JM, The Fabry-Perot Interferometer, Adam Hilger Bristol and Philadelphia, 2002). In Fig. 9 both principle ways are schematically shown. Either a mainly metallic or a dielectric system may be chosen. The metallic coatings can be protected by dielectric coatings for easier further processing.

The mirror is in one embodiment a metallic mirror designed as a fully reflective film. The mirror coating 31 can, for example, be painted on, printed on, sprayed on, or be deposited by means of a vacuum process. In one example, the mirror coating 31 contains mainly gold and is deposited by printing and is thickness is in the range of about 0.3 µm to about 10 µm.

In some embodiments, an evacuation line 14 leads through the first housing plate 1. This arrangement ensures accurate functioning of the measuring cell over a long period of time, since the reference vacuum chamber thereby has a high-quality vacuum with long-time stability. In the embodiment shown in Fig. 5 the evacuation line may connect the reference vacuum chamber 25 with a getter chamber 13 where a getter arrangement is placed which is not shown in Fig. 5. After evacuation a getter should be provided that is typically arranged in a small volume on the first housing and communicates with the reference vacuum chamber. This getter ensures that the reference vacuum pressure is lower, typically by at least one decade, than the pressure to be measured. To prevent contaminations of the internal measuring cell space a getter type that is not evaporating should be chosen. According to another embodiment, which can be combined with any other embodiment described herein, the evacuation line 14 connects the reference vacuum chamber 25 with a processing vacuum chamber, e.g. a coating chamber, in which the evaporator 10 including the ODG is provided for evaporation. In this case, the evacuation line 14 may be connected to the processing vacuum chamber instead of being connected to getter chamber 13 indicated in Fig. 5. Thereby, the reference vacuum inside of the reference vacuum chamber 25 substantially corresponds to the pressure or vacuum, respectively, provided in the processing vacuum chamber.

The first housing body 1 can be made fully of optical transparent material or include in the centre a transparent area forming an inserted optical window 33. An optical system is arranged directly or in distance behind the transparent housing 1 or the window 33 for coupling the Fabry-Perot interferometer to the reflecting surface of the moving membrane to be able to measure the deflection of the membrane 2 depending on the pressure to be measured. The light and the optical signal are fed from the interferometer to the measuring cell and from the measuring cell to the interferometer, respectively, by a least one glass fibre 37, 37'. In some examples, the inner surface 34 of the transparent housing 1 or of the window 33 inside of the reference vacuum chamber in opposition to the mirror 31 of the membrane 2 is coated with a partly transparent film, typically with a semitransparent film. This coating must withstand the backing temperature of several hundred °C when the measuring cell is mounted. In some embodiments, sapphire is used as transparent housing 1 or window 33 because of the optical behavior and the precision which can be reached. However this material is expensive and the use of an inserted window 33 is cheaper and the angle can be adjusted and optimized for good signal quality of the measuring system. If an inserted window 33 is used then it must be sealed by a seal 32 from the same type as already described above for sealing the membrane 2 with the seals 3, 3'. The seal material may consist of baked glass paste formed by heating up the paste on several hundred °C.

The measuring cell of the embodiment as shown in Fig. 5 is surrounded by a holder 28 and a heater 30. With this heater 30 the cell can be heated above the condensation temperature of the involved substances of the vacuum process to be measured. The temperature of the cell lays typically at least 10 °C above the condensation temperature. A typical temperature is in the range of 100 °C to 600 °C. The chemical substances used are often very aggressive and heating is an effective measure to keep them away from sensitive parts of the measuring cell. These measures ensure that the cell is working with high accuracy and high reproducibility during a long term of the executed processes.

In the heated measuring cell arrangement it is important that the optical system like the glass fibre becomes not to hot that it will not be destroyed and that the optical accuracy of the system is not badly influenced. As shown in Fig. 5 this problem can be solved while setting the fibre 37, 37' with its connector in a distance far away enough from the hot measuring cell that at the fibre the temperature is lower than 100 °C. For example the fibre can be in a distance of some cm away from the cell hold by a holder 28' like a tube from stainless steel to reduce the temperature. In this case a lens device, e.g. a lens, 35 is arranged between the fibre and the housing 1 or the window 33 for optimal coupling the optical signal to the membrane.

The whole measuring cell arrangement can be protected with a cover 29 surrounding it. In some examples, the measuring port 5 with the measuring vacuum chamber 26 and its membrane 2 is not directly exposed to the evaporation tube where aggressive conditions exist. In this case the port 5 is connected to a flange 40 with the interior of the evaporator tube by a baffle cavity 42 including a protection plate 41 as a baffle.

The membrane of some embodiments may be made as follows. Some ways to make a part of the reference vacuum side of the membrane reflective to optical light are: One method is to attach a small, thin reflective plate 31 on the alumina membrane. Another method is to evaporate a gold mirror 31 on a sapphire membrane. A chromium layer is placed between the sapphire and the gold to improve the adhesion of gold on sapphire. A further method is to paint it on, print it on or spray it on. The dielectric coatings are put instead or on top of the metallic layers in similar ways onto the membranes.

In further embodiments described herein, the membrane 2, also called herein diaphragm 2, is typically made of sapphire. Sapphire is in one embodiment a single crystal aluminum oxide (Al₂O₃; artificial corundum) with a definite crystal orientation. Therefore many physical parameters are dependent on direction.

This material choice has the following properties: It is corrosion resistant to process gases used in the semiconductor industry such as fluorides (NF₃, CH₂F₂, SF₆, CF₄, CHF₃) and chloride (e.g. Cl₂, HCl), bromides (e.g. HBr) gases or water vapor. Since it is monocrystalline it has a smoother surface than poly-crystalline alumina ceramic. This allows for smoother mirror surfaces. In addition a smooth monocrystalline surface reduces the number of thin film nucleation sites on the surface. This leads to reduced thin film deposition on the process side of the membrane 2 and therefore to less sensor drift due to slower membrane thin film stress build-up. It has a high flexural strength. This allows achieving larger deflections with thinner membranes 2, thereby allowing to extend the measurement range of the gauge and to achieve higher accuracy in the very low pressure range.

In some embodiments, the sapphire membrane 2 has a thickness below 150 µm. Thereby a higher deflection can be achieved than with Al₂O₃ up to the twice.

According to other embodiments, the membrane 2 is cut out of the sapphire crystal such that the membrane is typically perpendicular to the C-axis (structural index 0001). This orientation is to allow the greater thermal expansion coefficient to be perpendicular to the diaphragm instead of being perpendicular to it. This choice of axis orientation leads to increased thermal expansion in the vertical deflection and higher sensor drift as function of temperature. Thereby, it is intended to reduce buckling of the thin membrane. The sapphire membrane 2 of examples of embodiments has a diameter of about 5 to 80 mm with a typical range of about 5 to 40 mm and is about 0.04 to 0.76 mm thick with typical values of about 0.07 to 1.0 mm to avoid problems with buckling. The top and bottom plane should be parallel to 0.005 mm or better and have a surface roughness of N4 or Ra 0.35 or better in the area of the mirror 31.

In a further embodiment, as the mirror 31, a total reflection mirror may be used. Then, the mirror 31 on the reference vacuum side of the membrane 2 may be made of noble metals, typically gold. A chromium layer may be added to improve the adhesion of gold on sapphire. The sintering temperature for the noble metal coating like gold or silver is up to 850 °C. A single chromium layer might sometimes also be sufficient. An alternative solution consists out of a single or multilayer dielectric mirror.

The first housing body 1 can be made of alumina ceramic or sapphire. Use of a sapphire base results in a match of the thermal expansion coefficient of the base with the membrane. Due to cost reasons a first housing body made of alumina ceramic may be used. According to one example, in the housing body, a hole is drilled into which a semitransparent mirror as the window 33 is mounted as well as attachment pieces for the optical fibre.

In some embodiments, as the window 33 a semitransparent mirror may be used, e.g. as shown in Figs. 5, 8 and 9. The semitransparent mirror, also referred to herein as semireflective mirror, is in some embodiments made of chromium evaporated on a clear sapphire window surface 34. The chromium layer for instance has a thickness of about 5 nm. In order to further improve protection of the chromium layer from oxidation, optionally a protective tantalum pentoxide (Ta₂O₅) can be added on top of the chromium layer as protective layer.

The sapphire window 33 may be mounted e.g. with baked glass seals to the housing body in the same way as described before for mounting the membrane.

Good sensitivity of the pressure measuring device is achieved, when the mirror 31 on the membrane 2 and the semitransparent mirror 34 in the housing body 1 are substantially or precisely parallel. In some examples, a maximal tolerated tilt [α]+[β]+[γ] is 0.05 mrad, as shown in Fig. 8. Thereby, a substantial parallelism of the ODG cavity may be achieved.

In some embodiments, a baffle 41 is mounted in front of the sensor head and serves at least two purposes as shown in Fig. 5. First, it assures that there is no direct line of sight with the sensitive membrane 2. Gas particles therefore make at least two hits with other gauge surfaces before reaching the membrane 2. Easily condensing gases are typically deposited on the baffle surface before they condense on the membrane surface. This reduces the sensor drift and extends the life time of the sensor. The baffle also serves to convert a plasma into gas of a low charge state, typically neutral charge state, because of the necessary wall hit.

One embodiment includes a dive-in-sensor. The ODG sensor concept can also be used in a dive-in arrangement, an example of which is shown in Fig. 10. In this embodiment, the sensor cell is not retracted from the interior of the evaporator tube. The sensor head can be mounted directly on a flange 40, 40' of the evaporation tube 300, 310, 100. The sensor is then immersed in the interior of the evaporator tube. Membrane and sensor housing may be made of corrosion resistive materials.

In some examples of embodiments, multiplexed sensor heads may be provided. Optical read-out also allows for multiple sensor heads to be read out by a single spectrometer. This is achieved either using separate fibers which are stacked in parallel at the entrance slit of the spectrometer or by using bifurcated fibers or by fiber switches. The sensor heads can be at a location of the evaporator and, in addition, at different locations of the evaporator, of further evaporators, and of the coating installation. In some embodiments, several sensor heads may be placed next to each other on the same flange 40, 40'. This is shown in Fig. 10 schematically as a dive-in sensor with multiple heads. The heads can either be of the same type to allow redundancy or can be made of different types to cover overlapping or adjacent pressure ranges. This allows covering a larger range while using only one flange site at the evaporator.

When mounting several sensors on one flange 40, 40' with holding means 43, each individual sensor head may be adapted for a different pressure range by changing membrane dimensions. Thereby, one can measure the same and/or different pressure ranges, while using only one port at the evaporator tube. This is a cost reduction, since less time is needed for mounting and less time at interfacing sensors with his data acquisition system.

According to one embodiment, a method for applying vapor to a substrate includes: providing the vapor using an evaporator of any of above mentioned embodiments, applying the vapor to the substrate, and measuring the pressure of the vapor within the evaporator tube. According to embodiments, the evaporator includes an evaporator for applying vapor to a substrate at a coating rate, the evaporator including an evaporator tube having a distribution pipe with at least one nozzle outlet, and wherein the evaporator tube includes a pressure measurement device, the pressure measurement device including an optical diaphragm gauge.

The evaporator, the coating installation and the method of embodiments described herein allow for a determination of the deposition rate by a pressure measurement device included in the evaporator tube. According to embodiments described herein, the pressure measurement device includes an optical diaphragm gauge which is corrosion resistant and/or may be used in a high temperature and/or high EMI (Electro Magnetic Interference) surrounding.

According to one embodiment, an evaporator for applying vapor to a substrate at a coating rate is provided, the evaporator including an evaporator tube having a distribution pipe with at least one nozzle outlet, and wherein the evaporator tube includes a pressure measurement device, the pressure measurement device including an optical diaphragm gauge.

In one embodiment, which can be combined with any other embodiment described herein, the pressure measurement device is provided in the distribution pipe.

In one embodiment, which can be combined with any other embodiment described herein, the evaporator tube further includes a crucible and a supply tube connecting the crucible and the distribution pipe, the pressure measurement device being provided in one element selected from the group consisting of the supply tube and the crucible.

In one embodiment, which can be combined with any other embodiment described herein, the optical diaphragm gauge is a vacuum measuring cell, the vacuum measuring cell including a first housing body made of an Al₂O₃ material, a membrane made of an Al₂O₃ material, arranged adjacent to the first housing body in a vacuum tight manner such that a reference vacuum chamber is created between the first housing body and the membrane, a second housing body made of an Al₂O₃ material and provided opposite the membrane in a vacuum tight manner such that a measurement vacuum chamber is created between said second housing body and the membrane, said second housing body including a port for connecting the measurement vacuum chamber to the interior of the evaporator tube, wherein in the central area of the first housing body an optical transparent window is formed and at least in the central region of the membrane a surface of the membrane, which is located facing the optical transparent window, is formed optically reflecting, and wherein, outside of the reference vacuum chamber in opposition to and at a distance from the window, a light feeding device is arranged for feeding in and out light onto the surface of the membrane, and wherein a lens device is placed between the optical fibre and the window for optical linking to the surface of the membrane, such that the arrangement is forming a measuring section for determining the level of deflection of the membrane, e.g. using a Fabry-Perot Interferometer principle. In one embodiment, the arrangement is formed as a Fabry-Perot Interferometer.

In one embodiment, which can be combined with any other embodiment described herein, the pressure measuring device includes a plug, the optical diaphragm gauge is provided in the plug, and the plug is provided in an opening of the evaporator tube.

In one embodiment, which can be combined with any other embodiment described herein, the plug consists of quartz.

In one embodiment, which can be combined with any other embodiment described herein, the plug is cone-shaped.

In one embodiment, which can be combined with any other embodiment described herein, the pressure measuring device includes a plug, the optical diaphragm gauge is provided in the plug, and the plug is provided in an opening of the evaporator tube such that the measurement vacuum chamber of the optical diaphragm gauge is connected to the interior of the evaporator tube.

In one embodiment, which can be combined with any other embodiment described herein, said membrane of the vacuum measuring cell is made of Al₂O₃ from the type sapphire.

In one embodiment, which can be combined with any other embodiment described herein, said first housing body of the vacuum measuring cell consists at least partially of Al₂O₃ from the type sapphire and this part is placed in the central area for forming an optically transparent window.

In one embodiment, which can be combined with any other embodiment described herein, the optically transparent window is formed as a single insertion part made of sapphire and is mounted in a vacuum tight manner to the first housing body.

In one embodiment, which can be combined with any other embodiment described herein, the evaporator is an organic evaporator for applying organic vapor to a substrate at a coating rate.

According to a further embodiment, a coating installation for coating substrates is provided, with at least one evaporator for applying vapor to a substrate at a coating rate, the evaporator including an evaporator tube having a distribution pipe with at least one nozzle outlet, and wherein the evaporator tube includes a pressure measurement device, the pressure measurement device including an optical diaphragm gauge.

According to a yet further embodiment, a method for applying vapor to a substrate is provided, the method including: providing the vapor using an evaporator for applying vapor to a substrate at a coating rate, the evaporator including an evaporator tube having a distribution pipe with at least one nozzle outlet, and wherein the evaporator tube includes a pressure measurement device, the pressure measurement device including an optical diaphragm gauge, applying the vapor to the substrate, and measuring the pressure of the vapor within the evaporator tube.

In one embodiment, which can be combined with any other embodiment described herein, the vapor is provided within the distribution pipe and the pressure of the vapor is measured within the distribution pipe.

In one embodiment, which can be combined with any other embodiment described herein, the providing of the vapor includes the step of producing the vapor by heating material with the material being provided as a granulate material or as a material wire.

In one embodiment, which can be combined with any other embodiment described herein, the method further includes the step of structuring the substrate by means of a shadow mask.

In one embodiment, which can be combined with any other embodiment described herein, the vapor is an organic vapor, the method optionally further including the step of applying a non-organic cover coating to the substrate.

In one embodiment, which can be combined with any other embodiment described herein, the vapor is provided within the distribution pipe and the pressure of the vapor within the distribution pipe is adjusted between 2x10⁻¹² mbar and 4x10⁻² mbar.

In one embodiment, which can be combined with any other embodiment described herein, the optical diaphragm gauge includes a measuring section including a membrane made of at least one element selected from the group of a ceramic material, an Al₂O₃ material and Al₂O₃ from the type sapphire. In some embodiments, which can be combined with any other embodiment described herein, the optical diaphragm gauge is adapted to measure the deflection of the diaphragm or of the membrane, respectively.

## Claims

1. An evaporator for applying vapor to a substrate at a coating rate, the evaporator comprising
an evaporator tube (300, 310, 100) having a distribution pipe (100) with at least one nozzle outlet (110), and
wherein the evaporator tube includes a pressure measurement device (10, 12) provided in the evaporator tube, the pressure measurement device comprising an optical diaphragm gauge (10).

2. The evaporator according to claim 1, wherein the pressure measurement device (10) is provided in the distribution pipe (100).

3. The evaporator according to any of the preceding claims, the evaporator tube further comprising a crucible (300) and a supply tube (310) connecting the crucible and the distribution pipe, the pressure measurement device being provided in one element selected from the group consisting of the supply tube and the crucible.

4. The evaporator according to any of the preceding claims, wherein the optical diaphragm gauge comprises a measuring section including a membrane made of at least one element selected from the group of a ceramic material, an Al₂O₃ material and Al₂O₃ from the type sapphire.

5. The evaporator according to any of the preceding claims, wherein the optical diaphragm gauge is a vacuum measuring cell, the vacuum measuring cell comprising
a first housing body (1) made of an Al₂O₃ material,
a membrane (2) made of an Al₂O₃ material, arranged adjacent to the first housing body in a vacuum tight manner such that a reference vacuum chamber is created between the first housing body and the membrane,
a second housing body (4) made of an Al₂O₃ material and provided opposite the membrane (2) in a vacuum tight manner such that a measurement vacuum chamber (26) is created between said second housing body and the membrane, said second housing body including a port (5) for connecting the measurement vacuum chamber to the interior of the evaporator tube,
wherein in the central area of the first housing body an optical transparent window (33) is formed and at least in the central region of the membrane a surface of the membrane, which is located facing the optical transparent window, is formed optically reflecting, and wherein, outside of the reference vacuum chamber in opposition to and at a distance from the window (33), an light feeding means (37. 37') is arranged for feeding in and out light onto the surface (31) of the membrane (2), and
wherein a lens device (35) is placed between the optical fibre (37) and the window (33) for optical linking to the surface (31) of the membrane (2), such that the arrangement is forming a measuring section for determining the level of deflection of the membrane (2).

6. The evaporator according to any of the preceding claims, wherein the pressure measuring device includes a plug, the optical diaphragm gauge is provided in the plug, and the plug is provided in an opening of the evaporator tube such that the measurement vacuum chamber of the optical diaphragm gauge is connected to the interior of the evaporator tube, the plug optionally consisting of quartz and being cone-shaped.

7. The evaporator according to any of the preceding claims, wherein said membrane (2) of the vacuum measuring cell is made of Al₂O₃ from the type sapphire.

8. The evaporator according to any of the preceding claims, wherein said first housing body (1) of the vacuum measuring cell consists at least partially of Al₂O₃ from the type sapphire and this part is placed in the central area for forming an optically transparent window (33), and/or wherein the optically transparent window (33) is formed as a single insertion part made of sapphire and is mounted in a vacuum tight manner to the first housing body (1).

9. The evaporator according to any of the preceding claims, wherein the evaporator is an organic evaporator for applying organic vapor to a substrate at a coating rate.

10. A coating installation for coating substrates, with at least one evaporator according to any of the preceding claims.

11. A method for applying vapor to a substrate comprising:
providing the vapor using an evaporator according to any of claims 1 to 9,
applying the vapor to the substrate, and
measuring the pressure of the vapor within the evaporator tube.

12. The method according to claim 11, wherein the vapor is provided within the distribution pipe and the pressure of the vapor is measured within the distribution pipe.

13. The method according to claim 11 or 12, wherein the providing of the vapor comprises the step of producing the vapor by heating material with the material being provided as a granulate material or as a material wire.

14. The method according to any of claims 11 to 13, wherein the vapor is an organic vapor, the method optionally further comprising the step of applying a non-organic cover coating to the substrate.

15. A method according to any of claims 11 to 14, wherein the vapor is provided within the distribution pipe and the pressure of the vapor within the distribution pipe is adjusted between 2x10⁻¹² mbar and 4x10⁻² mbar.

## Patentansprüche

1. Verdampfer zum Aufbringen von Dampf auf einem Substrat bei einer Beschichtungsrate, wobei der Verdampfer umfasst:
ein Verdampferrohr (300, 310, 100), das eine Verteilerröhre (100) mit zumindest einem Düsenauslass (110) aufweist, und
wobei das Verdampferrohr eine Druckmessvorrichtung (10, 12) einschließt, die in dem Verdampferrohr bereitgestellt ist, wobei die Druckmessvorrichtung ein optisches Blendenmanometer (10) umfasst.

2. Verdampfer nach Anspruch 1, wobei die Druckmessvorrichtung (10) in der Verteilerröhre (100) bereitgestellt ist.

3. Verdampfer nach einem der voranstehenden Ansprüche, wobei das Verdampferrohr ferner einen Tiegel (300) und ein Zufuhrrohr (310) umfasst, das den Tiegel und die Verteilerröhre verbindet, wobei die Druckmessvorrichtung in einem Element bereitgestellt ist, das gewählt ist aus der Gruppe, die aus dem Zufuhrrohr und dem Tiegel besteht.

4. Verdampfer nach einem der voranstehenden Ansprüche, wobei das optische Blendenmanometer einen Messabschnitt umfasst, der eine Membran einschließt, die aus zumindest einem Element ausgeführt ist, das gewählt ist aus der Gruppe eines keramischen Materials, eines Al₂O₃-Materials und eines Al₂O₃ vom Saphir-Typ.

5. Verdampfer nach einem der voranstehenden Ansprüche, wobei das optische Blendenmanometer eine Vakuum-Messzelle ist, wobei die Vakuum-Messzelle umfasst:
einen ersten Gehäusekörper (1), der aus einem Al₂O₃-Material ausgeführt ist,
eine Membran (2), die aus einem Al₂O₃-Material ausgeführt ist, angeordnet angrenzend an den ersten Gehäusekörper auf eine vakuumdichte Weise derart,
dass eine Referenz-Vakuumkammer zwischen dem ersten Gehäusekörper und
der Membran geschaffen wird,
einen zweiten Gehäusekörper (4), der aus einem Al₂O₃-Material ausgeführt ist und gegenüber der Membran (2) auf eine vakuumdichte Weise derart bereitgestellt ist, dass eine Mess-Vakuumkammer (26) zwischen dem zweiten Gehäusekörper und der Membran geschaffen wird, wobei der zweite Gehäusekörper einen Anschluss (5) zum Verbinden der Mess-Vakuumkammer mit dem Inneren des Verdampferrohrs einschließt,
wobei in dem zentralen Bereich des ersten Gehäusekörpers ein optisch transparentes Fenster (33) gebildet ist und zumindest in dem zentralen Bereich der Membran eine Oberfläche der Membran, die gegenüber des optisch transparenten Fensters lokalisiert ist, optisch reflektierend ausgebildet ist, und
wobei außerhalb der Referenz-Vakuumkammer gegenüberliegend zu und in einem Abstand von dem Fenster (33) eine Lichtzufuhreinrichtung (37, 37') zum Ein- und Auskoppeln von Licht auf und von der Oberfläche (31) der Membran (2) angeordnet ist, und
wobei eine Linsenvorrichtung (35) zwischen der optischen Faser (37) und dem Fenster (33) zum optischen Verbinden mit der Oberfläche (31) der Membran (2) platziert ist, derart, dass die Anordnung einen Messabschnitt zum Bestimmen des Ablenkungsmaßes der Membran (2) ausbildet.

6. Verdampfer nach einem der voranstehenden Ansprüche, wobei die Druckmessvorrichtung einen Stecker einschließt, das optische Blendenmanometer in dem Stecker bereitgestellt ist, und der Stecker in einer Öffnung des Verdampferrohrs bereitgestellt ist, derart, dass die Mess-Vakuumkammer des optischen Blendenmanometers mit dem Inneren des Vakuumrohrs verbunden ist, wobei der Stecker wahlweise aus Quarz besteht und konusförmig ist.

7. Verdampfer nach einem der voranstehenden Ansprüche, wobei die Membran (2) der Vakuum-Messzelle aus Al₂O₃ vom Saphir-Typ ausgeführt ist.

8. Verdampfer nach einem der voranstehenden Ansprüche, wobei der erste Gehäusekörper (1) der Vakuum-Messzelle zumindest teilweise aus Al₂O₃ vom Saphir-Typ besteht und dieser Teil in dem zentralen Bereich zum Bilden eines optisch transparenten Fensters (33) platziert ist, und/oder wobei das optisch transparente Fenster (33) als ein einzelnes Einfügungsteil, das aus Saphir ausgeführt ist, ausgebildet ist und auf eine vakuumdichte Weise an dem ersten Gehäusekörper (1) befestigt ist.

9. Verdampfer nach einem der voranstehenden Ansprüche, wobei der Verdampfer ein organischer Verdampfer zum Aufbringen von organischem Dampf auf einem Substrat bei einer Beschichtungsrate ist.

10. Beschichtungsvorrichtung zum Beschichten von Substraten mit zumindest einem Verdampfer nach einem der voranstehenden Ansprüche.

11. Verfahren zum Aufbringen von Dampf auf einem Substrat, umfassend:
Bereitstellen des Dampfs unter Verwendung eines Verdampfers nach einem der Ansprüche 1 bis 9,
Aufbringen des Dampfs auf dem Substrat, und
Messen des Dampfdrucks innerhalb des Verdampferrohrs.

12. Verfahren nach Anspruch 11, wobei der Dampf innerhalb der Verteilerröhre bereitgestellt ist und der Dampfdruck innerhalb der Verteilerröhre gemessen wird.

13. Verfahren nach Anspruch 11 oder 12, wobei das Bereitstellen des Dampfs den Schritt eines Erzeugens des Dampfs durch Erwärmen von Material umfasst, wobei das Material als ein Granulatmaterial oder als ein Materialdraht bereitgestellt wird.

14. Verfahren nach einem der Ansprüche 11 bis 13, wobei der Dampf ein organischer Dampf ist, wobei das Verfahren wahlweise ferner den Schritt eines Aufbringens einer nicht-organischen Abdeckbeschichtung auf dem Substrat umfasst.

15. Verfahren nach einem der Ansprüche 11 bis 14, wobei der Dampf innerhalb der Verteilerröhre bereitgestellt wird und der Dampfdruck innerhalb der Verteilerröhre zwischen 2x10⁻¹² mbar und 4x10⁻² mbar eingestellt wird.

## Revendications

1. Evaporateur pour appliquer de la vapeur à un substrat à une vitesse de revêtement, l'évaporateur comprenant
un tube d'évaporateur (300, 310, 100) ayant un conduit de distribution (100) avec au moins une sortie de buse (110), et
dans lequel le tube d'évaporateur inclut un dispositif de mesure de pression (10, 12) agencé dans le tube d'évaporateur, le dispositif de mesure de pression comprenant un manomètre à diaphragme optique (10).

2. Evaporateur selon la revendication 1, dans lequel le dispositif de mesure de pression (10) est agencé dans le conduit de distribution (100).

3. Evaporateur selon l'une quelconque des revendications précédentes, le tube d'évaporateur comprenant en outre un creuset (300) et un tube d'alimentation (310) reliant le creuset et le conduit de distribution, le dispositif de mesure de étant agencé dans un élément choisi parmi le groupe constitué du tube d'alimentation et du creuset.

4. Evaporateur selon l'une quelconque des revendications précédentes, dans lequel le manomètre à diaphragme optique comprend une de mesure incluant une membrane constituée d'au moins un élément choisi parmi le groupe constitué d'un matériau céramique, d'un matériau Al₂O₃ et d'Al₂O₃ du type saphir.

5. Evaporateur selon l'une quelconque des revendications précédentes, dans lequel le manomètre à diaphragme optique est une cellule de mesure de vide, la cellule de mesure de vide comprenant
un premier corps de (1) constitué d'un matériau Al₂O₃,
une membrane (2) constituée d'un matériau Al₂O₃, agencée au voisinage du premier corps de boîtier d'une manière étanche au vide de telle sorte qu'une chambre à de référence est créée entre le premier due et la membrane,
une second due boîtier (4) constitué d'un matériau Al₂O₃ et disposé à l'opposé de la membrane (2) d'une manière étanche au vide de telle sorte qu'une chambre à vide de mesure (26) est créée entre ledit second corps de boîtier et la membrane, ledit second corps de boîtier incluant un orifice (5) pour relier la chambre à vide de mesure à l'intérieur du tube d'évaporateur,
dans lequel, dans la zone centrale du premier corps de boîtier, une fenêtre optique transparente (33) est formée et au moins dans la zone centrale de la membrane, une surface de la membrane, qui est dirigée vers la fenêtre optique transparente, est formée optiquement réfléchissante, et
dans lequel, à l'extérieur de la chambre à vide de référence en opposition à la fenêtre (33) et à une de celle-ci, des moyens d'acheminement de lumière (37, 37') sont disposés pour faire entrer et sortir de la lumière sur la surface (31) de la membrane (2), et
dans lequel un dispositif de lentille (35) est placé entre la fibre optique (37) et la (33) pour une liaison optique à la surface (31) de la membrane (2), de telle sorte que l'agencement forme une partie de mesure pour déterminer le niveau de déviation de la membrane (2).

6. Evaporateur selon l'une quelconque des revendications précédentes, dans lequel le dispositif de mesure de pression inclut un bouchon, le manomètre à diaphragme optique est disposé dans le bouchon, et le bouchon est agencé dans une ouverture du tube d'évaporateur due sorte que la à vide de mesure du manomètre à diaphragme optique est repliée à l'intérieur du tube d'évaporateur, le bouchon étant facultativement due quartz et étant en forme de cône.

7. Evaporateur selon l'une quelconque des revendications précédentes, dans lequel ladite membrane (2) de la cellule de mesure de vide est constituée d'Al₂O₃ du type saphir.

8. Evaporateur selon l'une quelconque des revendications précédentes, dans lequel ledit premier de boîtier (1) de la cellule de mesure de vide est constitué au moins en partie d'Al₂O₃ du type saphir et cette partie est placée dans la zone centrale pour former une fenêtre optiquement transparente (33), et/ou dans lequel la fenêtre optiquement transparente (33) est formée comme une seule partie d'insertion due saphir et est montée d'une manière au vide sur le premier corps de boîtier (1).

9. Evaporateur selon l'une quelconque des revendications précédentes, dans lequel l'évaporateur est un évaporateur organique pour appliquer de la vapeur organique à un à une vitesse de revêtement.

10. Installation de revêtement pour revêtir des substrats, avec au moins un évaporateur selon l'une quelconque des revendications précédentes.

11. Procédé pour appliquer de la vapeur à un substrat, comprenant :
la fourniture de la vapeur en utilisant un évaporateur selon l'une quelconque des revendications 1 à 9,
l'application de la vapeur au substrat, et
la mesure de la pression de la vapeur à l'intérieur du tube d'évaporateur.

12. Procédé selon la revendication 11, dans lequel la vapeur est à l'intérieur du conduit de distribution et la pression de la vapeur est mesurée à l'intérieur du conduit de distribution.

13. Procédé selon la revendication 11 ou 12, dans lequel la fourniture de la vapeur comprend l'étape de de la vapeur en chauffant un matériau, le matériau étant fourni sous la forme d'un matériau ou sous la forme d'un fil de matériau.

14. Procédé selon l'une quelconque des revendications 11 à 13, dans lequel la vapeur est une vapeur organique, le procédé comprenant en outre facultativement l'étape d'application d'un revêtement de recouvrement non organique sur le substrat.

15. Procédé selon l'une quelconque des revendications 11 à 14, dans lequel la vapeur est fournie à l'intérieur du conduit de distribution et la pression de la vapeur à l'intérieur du conduit de distribution est réglée entre 2 × 10⁻¹² mbar et 4 x 10⁻² mbar.
